(19) Europäisches Patentamt
European Patent Office
Office européen des brevets

(11) **EP 1 261 125 B1**

(12) **FASCICULE DE BREVET EUROPEEN**

(45) Date de publication et mention
de la délivrance du brevet:
**07.03.2007 Bulletin 2007/10**

(51) Int Cl.:
***H03H 17/04*** *(2006.01)*

(21) Numéro de dépôt: **01401369.2**

(22) Date de dépôt: **23.05.2001**

(54) **Procédé de filtrage à large dynamique pour filtre numérique récursif implanté dans un processeur de signal DSP travaillant avec des nombres entiers**

Filterungsverfahren mit großem Dynamikbereich für digitales rekursives Filter in einer Signalverarbeitungseinrichtung unter Verwendung von Integer-Zahlen

Wide dynamic range filtering method for recursive digital filter in a signal processor (DPS) operating with integer numbers

(84) Etats contractants désignés:
**DE FR GB IT NL**

(43) Date de publication de la demande:
**27.11.2002 Bulletin 2002/48**

(73) Titulaire: **Institut Franco-Allemand de Recherches de Saint-Louis**
**68301 Saint-Louis Cedex (FR)**

(72) Inventeurs:
• **Zimpfer, Véronique**
**68300 Saint Louis (FR)**
• **Buck, Karl**
**68870 Bartenheim (FR)**

(74) Mandataire: **Le Moenner, Annie**
**Bureau de la Propriété Industrielle**
**DGA/DSP/SDAG/BPI**
**Bâtiment 105**
**16 bis, Av. Prieur de la Côte d'Or**
**94114 Arcueil Cedex (FR)**

(56) Documents cités:
**US-A- 4 195 350** **US-A- 5 999 955**

• **ZHDANOV O P ET AL: "THE STRUCTURE OF A RECURSIVE DIGITAL LEVEL WITHOUT LIMIT CYCLES WITH LOW ROUNDING NOISE*" TELECOMMUNICATIONS AND RADIO ENGINEERING, BEGELL HOUSE, INC., NEW YORK, NY, US, vol. 46, no. 3, 1 mars 1991 (1991-03-01), pages 62-67, XP000297052 ISSN: 0040-2508**

**EP 1 261 125 B1**

**Description**

Le domaine technique de la présente invention est celui des filtres numériques récursifs (à réponse impulsionnelle infinie ou RII) et de leurs applications industrielles.

Ceux-ci sont utilisés en particulier, mais non exclusivement, dans le domaine de la réduction du bruit, pour la réalisation de protections acoustiques actives. Ils peuvent également être utilisés dans les systèmes de régulation qui utilisent des boucles de contre-réaction.

Dans ce domaine, plusieurs réalisations ont déjà été proposées, p. ex. dans le document «The Structure of a Recursive Digital Level without Limit Cycles with Low Rounding Noise» by O.P. Zhdanov et al. in Telecommunications and Radio Engineering, vol. 46, no. 3, pp. 62-67, 01.03.1991. Elles reposent sur la transformation d'un signal d'entrée x(n) à un instant donné, issu d'un échantillonnage à une fréquence donnée, en un signal de sortie y(n) qui en est déduit par un procédé de calcul déterminé. Ce procédé de calcul est défini par les coefficients $a_j$ et $b_i$ de la fonction F(z) représentative de la fonction de transfert du filtre sous sa forme générale dans le plan complexe

$$F(Z) = \frac{1}{K} \frac{\sum_{i=0}^{p} b_i \cdot Z^{-1}}{1 + \sum_{j=1}^{q} a_j \cdot Z^{-1}}$$

ou encore de l'équation aux différences finies qui donne la valeur du signal de sortie en fonction des valeurs d'entrée et de sortie pour les échantillons antérieurs n-i ou n-j :

$$y(n) = \frac{1}{K} \sum_{i=0}^{p} (b_i \cdot x(n-i)) - \sum_{j=1}^{q} (a_j \cdot y(n-j))$$

où K désigne un coefficient permettant de régler le gain du filtre et Z un nombre complexe tel que $Z=exp(2\pi jf)$ où f est la fréquence réduite, valeur sans unité comprise entre 0 et 1, définie par la fréquence réelle du signal exprimée en Hz divisée par la fréquence d'échantillonnage exprimée également en Hz, et où *j est* le nombre complexe tel que $j^2=-1$.

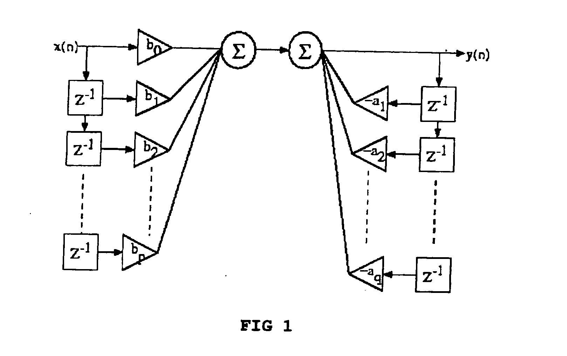

La forme générale des filtres numériques récursifs peut alors être représentée par le schéma de la figure 1, dans lequel $Z^{-1}$ est l'opérateur permettant de passer de l'échantillon n à l'échantillon n-1.

L'implémentation de ces filtres est généralement réalisée par une succession de filtres du second ordre (filtres ne faisant intervenir que les valeurs d'entrée et de sorties des deux échantillons précédents), disposés en parallèle (forme parallèle) ou en cascade (forme cascade), avec une fonction de transfert qui s'écrit alors de la manière suivante, respectivement pour les filtres en parallèle et en cascade :

$$F(Z) = \prod_{i=1}^{m} F_i(Z) \qquad ou \qquad F(Z) = \sum_{i=1}^{m} F_i(Z)$$

Où $F_i(Z)$ représente la fonction de transfert de chaque filtre élémentaire récursif du second ordre.

Chaque cellule (filtre élémentaire récursif du second ordre) est ainsi définie seulement par les cinq coefficients $a_1$, $a_2$, $b_0$, $b_1$ et $b_2$.

Ces filtres, quel que soit leur ordre, ont pour inconvénient de ne pouvoir être réalisés qu'après une quantification de leurs coefficients en nombres entiers, c'est à dire avec une troncature des décimales, qui n'intervient qu'après que les coefficients réels $a_j$ et $b_i$ aient été multipliés par un facteur d'échelle.Ce facteur d'échelle permet d'accroître le choix possible pour les coefficients en entier utilisés dans le calcul, alors que les coefficients réels sont au plus compris entre -2 et 2. Cette troncature entraîne une erreur qui se traduit par des non-linéarités du filtre, qui le rendent impropre à la fonction de filtrage souhaitée. Pour minimiser l'effet de la quantification des coefficients en entier il est nécessaire de réaliser le filtre par une succession de filtres du second ordre en cascade (forme cascade). A cette erreur sur les coefficients s'ajoute l'erreur d'arrondi qui se produit lors des divisions entières par le facteur d'échelle. Cette erreur d'arrondi se propage d'échantillon en échantillon au fil des calculs effectués. Elle peut devenir très grande, donc non négligeable lorsque le filtre fonctionne dans le domaine des basses fréquences. Cette erreur est encore aggravée si on prend pour résultat des divisions entières par le facteur d'échelle la valeur entière par défaut au lieu de la valeur entière la plus proche du résultat de la division réelle.

Le but de la présente invention est de remédier à ces inconvénients en proposant un procédé de calcul qui évite la propagation des erreurs d'arrondi et qui retient l'entier le plus proche du résultat dans les divisions entières.

Pour ce faire, l'invention propose de compléter le procédé de calcul du signal de sortie par une prise en compte des restes des divisions entières effectuées lors du calcul du signal de sortie des échantillons antérieurs. Ce calcul est effectué selon l'équation suivante (indiquée ici dans le cas particulier d'une cellule du second ordre) :

$$y(n) = Q\left( \frac{Q\left( \frac{ech \cdot x(n) + b_1 \cdot x(n-1) + b_2 \cdot x(n-2)}{K} \right) - a_1 \cdot y(n-1) - a_2 \cdot y(n-2) + Q\left( \frac{-a_1 \cdot r(n-1) - a_2 \cdot r(n-2)}{ech} \right)}{ech} \right)$$

au lieu de :

$$y(n) = Q\left( \frac{Q\left( \frac{ech \cdot x(n) + b_1 \cdot x(n-1) + b_2 \cdot x(n-2)}{K} \right) - a_1 \cdot y(n-1) - a_2 \cdot y(n-2)}{ech} \right)$$

pour un calcul classique d'un filtre numérique récursif implémenté, dans laquelle Q( ) est l'opérateur non-linéaire de quantification lors des divisions entières et "ech" le facteur d'échelle choisi.

Ces formules sont bien évidement à adapter par augmentation du nombre d'éléments dans le calcul ($a_1$, $a_2$, $a_3$, ..., $b_1$, $b_2$, $b_3$, ..., n-1, n-2, n-3, ...) si les filtres à réaliser sont d'un ordre supérieur à deux.

L'invention propose également de compléter le procédé de calcul du signal de sortie par un procédé qui remplace l'arrondi à la valeur entière par défaut lors de la division par le facteur d'échelle par l'arrondi à la valeur entière la plus proche du résultat en valeur réelle.

Dans ces conditions, il est possible de montrer que l'erreur entre la valeur calculée *y(n)* et la valeur théorique *th(n)* que l'on obtiendrait sans les erreurs d'arrondi est indépendante des erreurs commises sur les itérations précédentes. Il n'y a alors plus de phénomène de propagation, et par suite d'amplification de l'erreur. Celle-ci, au rang n, est ainsi minimisée et le filtre obtenu peut réaliser sa fonction de filtrage quelle que soit l'amplitude du signal d'entrée. La dynamique du filtre ainsi réalisé peut dépasser 60 dB ; c'est à dire que l'erreur reste négligeable même si l'amplitude du signal d'entrée est comprise entre l'amplitude maximale et l'amplitude maximale moins 60 dB (amplitude maximale/1000).

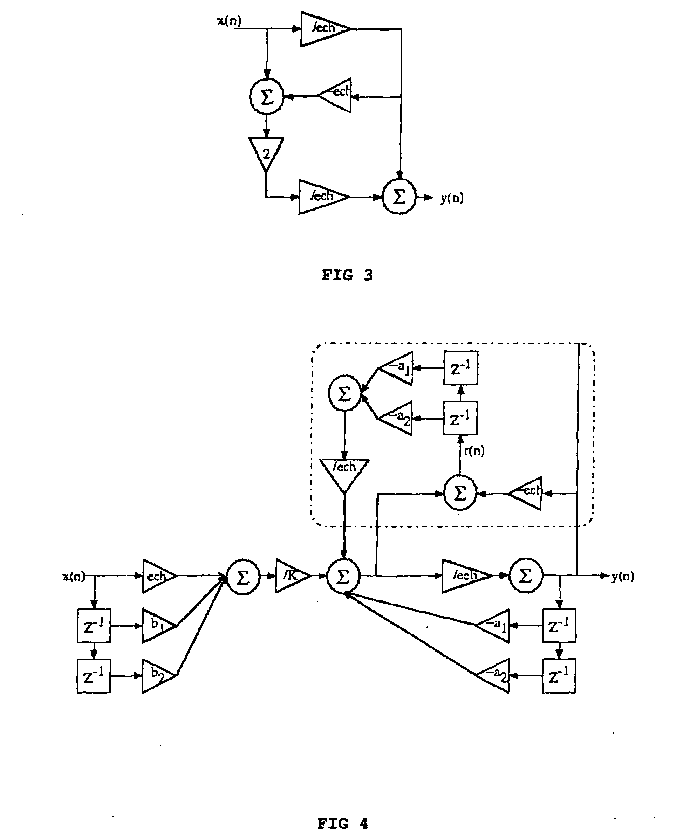

L'invention comporte de façon principale un procédé de non propagation de l'erreur d'arrondi, explicité dans la figure 4, pour lequel :

- on prélève le signal de sortie que l'on multiplie par le facteur d'échelle et après avoir changé le signe du résultat on l'additionne à la valeur du signal de sortie obtenue avant d'effectuer la division par le facteur d'échelle afin d'obtenir le reste de la division entière au rang n,
- on applique à ce reste l'opérateur $Z^{-1}$ une première fois pour obtenir le reste de la division dans le calcul de l'échantillon de rang n-1, auquel on applique une multiplication par le coefficient $-a_1$,
- on applique à cette valeur l'opérateur $Z^{-1}$ une seconde fois pour obtenir le reste de la division dans le calcul de l'échantillon de rang n-2, auquel on applique une multiplication par le coefficient $-a_2$,
- et ainsi de suite jusqu'au rang retenu pour l'ordre du filtre,
- on somme ces divers résultats pour ensuite diviser le résultat obtenu par le facteur d'échelle et ajouter la valeur ainsi obtenue au calcul du signal de sortie.

Le procédé de calcul défini dans l'invention comporte également, de façon avantageuse mais non obligatoire, un procédé de division dite améliorée, explicité dans la figure 3, qui consiste à diviser le signal par le facteur d'échelle, puis à le multiplier à nouveau par le facteur d'échelle pour le soustraire au signal initial ; le résultat de cette soustraction est multiplié par 2 pour ensuite être divisé par le facteur d'échelle et enfin ajouté au signal initial après division de celui-ci par le facteur d'échelle.

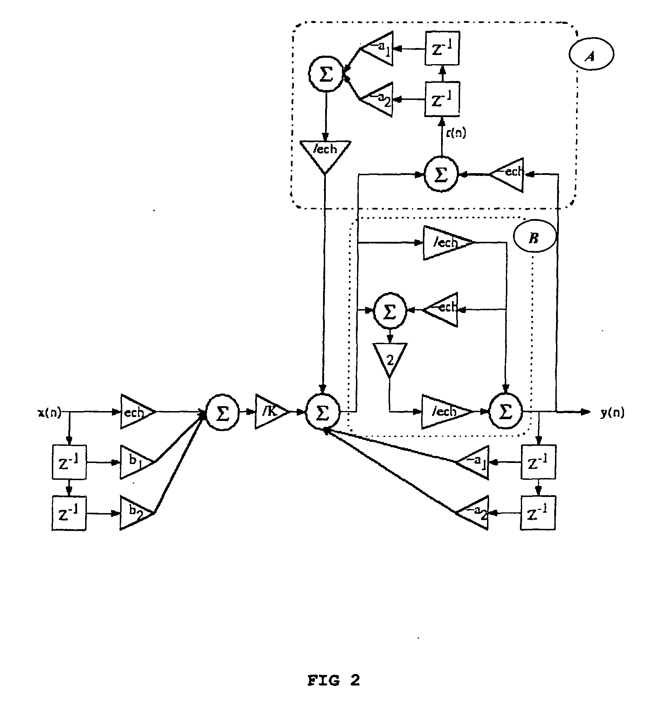

En référence aux figures 2 à 4 on voit le procédé de calcul selon l'invention, réalisé en se limitant à une cellule du second ordre. Pour un filtre numérique constitué par m cellules du second ordre en cascade, l'invention consiste à appliquer pour chacune des m cellules le calcul de son signal de sortie qui est représenté dans la figure 2. Le signal d'entrée de la $i^{ème}$ cellule est le signal de sortie de la cellule antérieure.

La figure 2 représente le procédé complet pour une cellule du second ordre, avec une identification du procédé de non propagation de l'erreur d'arrondi au moyen d'un trait semipointillé (points et traits alternés) et de la lettre *A* placée dans une ellipse, et une identification du procédé de la division améliorée au moyen d'un trait pointillé et de la lettre *B* placée elle aussi dans une ellipse. Dans cette figure x(n) est le signal d'entrée, y(n) le signal de sortie et r(n) le reste de la division par le facteur d'échelle. Dans l'hypothèse où le filtre numérique est constitué par plusieurs cellules du second ordre en cascade, le procédé doit être reconduit pour chacune d'elles.

La figure 3 décrit le procédé de la division améliorée, isolément du procédé complet de calcul du signal de sortie pour une cellule du second ordre.

La figure 4 décrit le procédé complet de calcul pour une cellule du second ordre, lorsqu'il ne réalise que la fonction de non-propagation de l'erreur d'arrondi. Dans l'hypothèse où le filtre numérique est constitué par plusieurs cellules du second ordre en cascade, le procédé doit être reconduit pour chacune d'elles.

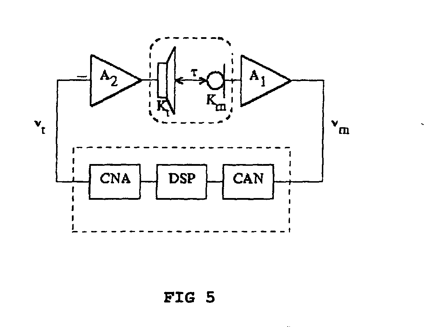

La figure 5 donne le synoptique de réalisation d'un système actif numérique pour une protection auditive, basé sur le filtrage objet de l'invention. Le pointillé supérieur représente le casque de protection et le pointillé inférieur le filtre numérique. Les modules CNA et CAN représentent les convertisseurs numérique/analogique et analogique/numérique qui, associés au processeur de signal DSP, permettent de réaliser le filtre numérique.

Un mode particulier de réalisation de l'invention est représenté par la figure 2. Dans cet exemple il est constitué d'une seule cellule du second ordre. Le signal entrant x(n) lors de l'itération n est multiplié par le facteur d'échelle; il est ajouté aux deux valeurs obtenues en multipliant respectivement les signaux entrant lors des itérations n-1 et n-2 par les coefficients $b_1$ et $b_2$. La valeur ainsi obtenue est divisée par le gain K retenu pour la cellule du second ordre. A cette valeur sont sommées les éléments suivants :

- les valeurs obtenues en multipliant respectivement les signaux sortants issus des itérations n-1 et n-2 par les coefficients $(-a_1)$ et $(-a_2)$
- et le résultat du calcul dit de la non propagation de l'erreur d'arrondi, à savoir la valeur obtenue en retranchant à la valeur issue de cette somme la valeur du signal de sortie y(n) après multiplication par le facteur d'échelle, puis application à cette valeur de l'opérateur $Z^{-1}$ pour obtenir le reste de la division par le facteur d'échelle issu du calcul du signal de sortie pour l'échantillon n-1, puis application à nouveau de cet opérateur pour obtenir le reste de la division par le facteur d'échelle issu du calcul du signal de sortie pour l'échantillon n-2, puis sommation de ces restes après multiplication respectivement par les coefficients $(-a_1)$ et $(-a_2)$ et pour finir division par le facteur d'échelle.

La valeur issue de ce calcul est ensuite modifiée pour obtenir la valeur de sortie y(n) par le procédé dit de la division améliorée, qui consiste à prélever le signal en sortie de l'opérateur de somme, le diviser par le facteur d'échelle, puis le multiplier à nouveau par le facteur d'échelle pour le soustraire au signal tel que prélevé, puis multiplier ce résultat par 2 pour ensuite le diviser par le facteur d'échelle et enfin l'ajouter au signal tel que prélevé, une fois que celui-ci a été divisé par le facteur d'échelle.

L'implémentation dans un processeur de signal de type DSP travaillant avec des nombres entiers d'un filtre du type décrit dans l'invention peut être réalisé de la façon suivante : On utilise un convertisseur de signal analogique/numérique et numérique/analogique en amont et aval du processeur de signal, de préférence de 16 bit ou plus afin de pouvoir négliger l'erreur due aux conversions devant l'amplitude du signal.

Afin d'éviter une erreur supplémentaire par dépassement de la dynamique du DSP on choisit pour facteur d'échelle un nombre entier inférieur ou égal à $2^{p-b-2}$ où p désigne la longueur des mots du DSP et b la résolution des convertisseurs (nombre de bits sur lequel ceux-ci codent le signal).

Il est par ailleurs préférable d'utiliser un facteur d'échelle et un coefficient de gain K multiples de 2 afin de minimiser le temps de calcul. Ceci permet de remplacer toutes les divisions, opérations lentes dans un DSP, par des décalages de registres qui sont des opérations très rapides. Enfin, plus le facteur d'échelle est grand, plus l'erreur due à la quantification des coefficients est faible et plus le nombre de filtres réalisables est important. Il est donc préférable d'utiliser un DSP avec une longueur de mot de 32 bit. Ceci permet de prendre pour facteur d'échelle la valeur ech=$2^{32-16-2}=2^{14}$=16384. Avec un filtre de ce type on peut réaliser des filtrages efficaces pour des dynamiques de signal dépassant 60dB.

Une utilisation pratique de ces filtres est la protection active contre le bruit, qui nécessite une large plage d'amplitude utilisable, quel que soit le filtre implémenté.

Le filtre numérique alors utilisé est un filtre de type RII sous sa forme en cascade. Chaque cellule de filtrage est implémentée dans le DSP en utilisant le procédé de calcul de l'invention représenté par la figure 2.

L'invention peut également être utilisée dans le domaine de la régulation, qui utilise des boucles de contre réaction, puisque le faible niveau de propagation de l'erreur peut permettre de remplacer les procédés de filtrage analogiques par des procédés numériques.

**EP 1 261 125 B1**

**Revendications**

1. Procédé de calcul pour la réalisation d'un filtre numérique récursif, implémenté dans un processeur de signal travaillant avec des nombres entiers, comprenant une étape de calcul du signal de sortie de l'échantillon n reposant sur une somme algébrique des valeurs d'entrée et de sortie des signaux échantillonnés à l'instant considéré et aux instants antérieurs, affectés des coefficients caractéristiques du filtre *caractérisé en ce qu'à* cette étape est couplée une autre première étape de calcul qui reprend les restes des divisions entières par le facteur d'échelle choisi, issus du calcul des signaux de sortie des échantillons antérieurs.

2. Procédé de calcul pour la réalisation d'un filtre numérique récursif, implémenté dans un processeur de signal travaillant avec des nombres entiers, comprenant une étape de calcul du signal de sortie de l'échantillon n reposant sur une somme algébrique des valeurs d'entrée et de sortie des signaux échantillonnés à l'instant considéré et aux instants antérieurs, affectés des coefficients caractéristiques du filtre *caractérisé en ce qu'à* cette étape est couplée une autre deuxième étape de calcul qui remplace l'arrondi à la valeur entière par défaut issue de la division du signal de sortie par le facteur d'échelle par l'arrondi à la valeur entière la plus proche du quotient en nombre réel.

3. Procédé de calcul pour la réalisation d'un filtre numérique récursif selon les deux revendications 1 et 2 *caractérisé en ce que* cette étape est couplée à l'autre première et à l'autre deuxième étapes de calcul.

4. Utilisation du procédé de calcul selon l'une des revendications 1, 2 ou 3 pour la réalisation d'un filtre numérique récursif.

5. Utilisation d'un filtre numérique selon la revendication 4 pour la réalisation d'un système de protection acoustique active.

6. Utilisation d'un filtre numérique selon la revendication 4 pour la réalisation d'un système de régulation à boucle de contre réaction.

**Claims**

1. Calculation method for producing a recursive digital filter, implemented in a signal processor working with integer numbers, including a step for calculating the output signal of sample n based on an algebraic sum of input and output values of signals sampled at the instant considered and at previous instants, and assigned coefficients characteristic of the filter,
**characterised in that** there is coupled with this step another first calculation step which takes the remainders of integer divisions by the chosen scale factor, which remainders result from the calculations of output signals of previous samples.

2. Calculation method for producing a recursive digital filter, implemented in a signal processor working with integer numbers, including a step for calculating the output signal of sample n based on an algebraic sum of input and output values of signals sampled at the instant considered and at previous instants, and assigned coefficients characteristic of the filter,
**characterised in that** there is coupled with this step another second calculation step which replaces the rounding to the default integer value resulting from the division of the output signal by the scale factor with the rounding to the nearest integer value of the real value quotient.

3. Calculation method for producing a recursive digital filter according to both Claims 1 and 2, **characterised in that** this step is coupled with the other first and the other second calculation steps.

4. Use of the calculation method according to one of Claims 1, 2 or 3 for producing a recursive digital filter.

5. Use of a digital filter according to Claim 4 for producing an active acoustic protection system.

6. Use of a digital filter according to Claim 4 for producing a regulating system with negative feedback loop.

**Patentansprüche**

1. Berechnungsverfahren für die Realisierung eines rekursiven digitalen Filters, das in einen Signalprozessor mit Ganzzahlarithmetik implementiert ist und welches eine Stufe zur Berechnung des Ausgangssignals der Probe n beinhaltet, die auf einer algebraischen Summe der Eingangs- und Ausgangswerte der ausgewählten Signale zum betrachteten Zeitpunkt und zu früheren Zeitpunkten unter Zuordnung der charakteristischen Filterkoeffizienten beruht, **dadurch gekennzeichnet, dass** diese Stufe an eine weitere erste Berechnungsstufe gekoppelt ist, welche die Reste der Ganzzahldivisionen durch den gewählten Maßstabfaktor, die sich aus der Berechnung der Ausgangssignale früherer Proben ergeben, verwendet.

2. Berechnungsverfahren für die Realisierung eines rekursiven digitalen Filters, das in einem Signalprozessor mit Ganzzahlarithmetik implementiert ist und welches eine Stufe zur Berechnung des Ausgangssignals der Probe n beinhaltet, die auf einer algebraischen Summe der Eingangs- und Ausgangswerte der ausgewählten Signale zum betrachteten Zeitpunkt und zu früheren Zeitpunkten unter Zuordnung der charakteristischen Filterkoeffizienten beruht, **dadurch gekennzeichnet, dass** diese Stufe an eine weitere zweite Berechnungsstufe gekoppelt ist, bei welcher der gerundete Wert aus der Division des Ausgangssignals durch den Maßstahfaktor durch ein Runden auf die nächste ganze Zahl des Realzahl-Quotienten ersetzt wird.

3. Berechnungsverfahren für die Realisierung eines rekursiven digitalen Filters gemäß den beiden Ansprüchen 1 und 2, **dadurch gekennzeichnet, dass** diese Stufe an die weitere erste und die weitere zweite Berechnungsstufe gekoppelt ist.

4. Verwendung des Berechnungsverfahrens gemäß einem der Ansprüche 1, 2 oder 3 zur Realisierung eines rekursiven digitalen Filters.

5. Verwendung eines digitalen Filters gemäß Anspruch 4 für die Realisierung eines aktiven Schallschutzsystems.

6. Verwendung eines digitalen Filters gemäß Anspruch 4 für die Realisierung eines Regelungssystems mit Rückkopplungsschleife.

FIG 1

FIG 2

FIG 3

FIG 4

FIG 5